# EUROPÄISCHE PATENTSCHRIFT

(11) **EP 1 989 599 B1**
(45) Veröffentlichungstag und Bekanntmachung des Hinweises auf die Patenterteilung: **22.07.2009**
(21) Anmeldenummer: 07721982.2
(22) Anmeldetag: 28.02.2007
(51) Int. Cl.: G05B 19/10, G05B 19/05, G05B 19/048, G05B 9/02, H01H 47/00, F16P 3/00

(54) **SCHALTGERÄT ZUR ABSICHERUNG GEFÄHRLICHER MASCHINEN**
SWITCHGEAR FOR SECURING DANGEROUS MACHINES
APPAREIL DE COMMUTATION DESTINÉ À SÉCURISER DES MACHINES DANGEREUSES

(30) Priorität: 28.02.2006 DE 202006003477 U
(43) Veröffentlichungstag der Anmeldung: 12.11.2008
(73) Patentinhaber: Pepperl + Fuchs GmbH, 12277 Berlin (DE)
(72) Erfinder: JURGEIT, Ralph-Rainer, 16356 Ahrensfelde (DE); SCHRANK, Oliver, 12167 Berlin (DE); ANSELM, Olaf, 13355 Berlin (DE)
(74) Vertreter: Meissner, Peter E.
(86) Internationale Anmeldenummer: PCT/DE2007/000407
(87) Internationale Veröffentlichungsnummer: WO 2007/098753

(56) Entgegenhaltungen:
- DE-A1- 10 020 074
- DE-C2- 10 020 075
- US-A- 4 215 386
- SCHLEICHER ELECTRONIC GMBH & CO KG: "Safety center / Modulare Sicherheitskleinsteuerung - Systembeschreibung 2003" INTERNET CITATION, [Online] 9. Mai 2003 (2003-05-09), XP002335996 Gefunden im Internet: URL:http://213.198.46.147/home/de_gb/downl oad/manuals/dt/pdf_relais/sc_sy stembeschreibung.pdf> [gefunden am 2005-07-13]

## Beschreibung

Die Erfindung betrifft ein modulares Schaltgerät, das ein erstes Ausgangsmodul und weitere Ausgangsmodule sowie Eingangsmodule und eine Einrichtung zur elektrischen Verbindung der genannten Module enthält.

Sicherheitsschaltgeräte werten Signale von Sicherheitssensoren in einer gegen Ausfälle abgesicherten Weise aus und steuern ihnen zugeordnete Aktoren an. Solche Sicherheitsschaltgeräte können modular aufgebaut sein, wobei die Module über Steckplätze einer Verbindungsvorrichtung miteinander verbunden sind. Solche modularen Geräte können Eingangsmodule enthalten, an die Sicherheitssensoren angeschlossen werden, und Ausgangsmodule, die die Aktoren steuern oder enthalten. Die Zuordnung der Eingangsmodule zu den Ausgangsmodulen kann in unterschiedlicher Weise erfolgen. So beschreibt das Patent DE 10020075C eine Anordnung, in der die Eingangsmodule über ihre physische Position innerhalb der Verbindungsvorrichtung den Ausgangmodulen zugeordnet sind.

DE 10020074 A1 offenbart ein modulares Sicherheitsschaltgeräte-System, bei dem die Zuordnung zwischen Eingangs- und Ausgangsmodulen mittels eines separaten Steuermoduls erfolgt.

Der vorliegenden Erfindung liegt die Aufgabe zugrunde, eine einfache und kostengünstige Zuordnung von Eingangsmodulen zu Ausgangsmodulen zu beschreiben.

Die Aufgabe wird erfindungsgemäß dadurch gelöst, dass das modulare Schaltgerät ein erstes Ausgangsmodul und weitere Ausgangsmodule sowie Eingangsmodule und eine Verbindungseinrichtung enthält, wobei jedes der genannten weiteren Ausgangsmodule mit einer Schalteinrichtung zur Einstellung einer Zahl ausgestattet ist, die eine Position an der Verbindungseinrichtung des Schaltgerätes repräsentiert, wobei jedem Ausgangsmodul alle Eingangsmodule ab der auf diesem Ausgangsmodul eingestellten Position bis zur auf einem anderen Ausgangsmodul eingestellten nächst höheren Position minus 1 zugeordnet sind, wobei dem Ausgangsmodul mit der höchsten eingestellten Position alle Eingangsmodule ab dieser Position bis zur letzten Position zugeordnet sind.

Der Kerngedanke der Erfindung besteht darin, dass die Zuordnung der Eingangsmodule zu den Ausgangsmodulen nicht durch deren physische Position sondern durch Schalterstellungen auf den Ausgangsmodulen bestimmt wird.

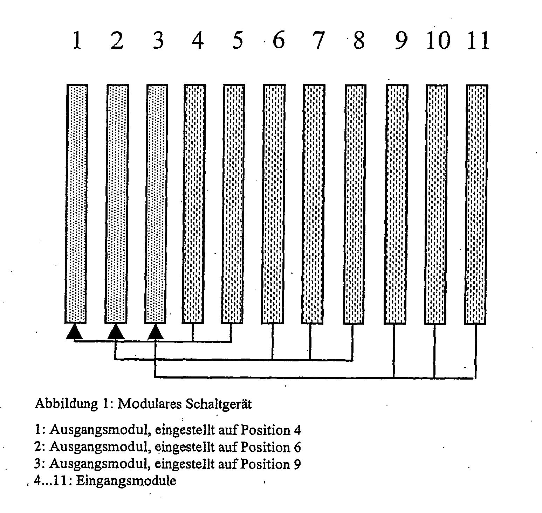

Die Erfindung soll nachfolgend an einem Ausführungsbeispiel mit Bezug auf die Zeichnung erläutert werden.

Die überwiegend identischen Steckplätze werden nachfolgend aufsteigend bei 1 beginnend nummeriert. Auf den Positionen 1...3 befinden sich Ausgangsmodule und auf den Positionen 4...11 Eingangsmodule. Die Schalteinrichtungen der Ausgangsmodule auf den Positionen 1, 2 und 3 sind auf 4, 6 bzw. 9 eingestellt. Im Ergebnis dieser Einstellungen wirken die Eingangsmodule auf den Positionen 4 und 5 auf das Ausgangsmodul auf der Position 1, die Eingangsmodule auf den Positionen 6, 7, 8 auf das Ausgangsmodul auf der Position 2 und die Eingangsmodule auf den Positionen 9, 10, 11 auf das Ausgangsmodul auf der Position 3.

## Patentansprüche

1. Modulares Schaltgerät, das ein erstes Ausgangsmodul und weitere Ausgangsmodule sowie Eingangsmodule und eine Verbindungseinrichtung zur elektrischen Verbindung der genannten Module enthält,
**gekennzeichnet dadurch,**
**dass** jedes der genannten weiteren Ausgangsmodule mit einer Schalteinrichtung zur Einstellung einer Zahl ausgestattet ist, die eine Position an der Verbindungseinrichtung des Schaltgerätes repräsentiert, wobei jedem Ausgangsmodul alle Eingangsmodule ab der auf diesem Ausgangsmodul eingestellten Position bis zur auf einem anderen Ausgangsmodul eingestellten nächst höheren Position minus 1 zugeordnet sind, wobei dem Ausgangsmodul mit der höchsten eingestellten Position alle Eingangsmodule ab dieser Position bis zur letzten Position zugeordnet sind.

2. Modulares Schaltgerät nach Anspruch 1,
**dadurch gekennzeichnet,**
**dass** zusätzlich zu den genannten Eingangs- und Ausgangsmodulen auch andere Module enthalten sind, deren Zuordnung zu den Eingangs- und Ausgangsmodulen in anderer Weise bestimmt wird.

## Claims

1. Modular switching device, which contains a first output module and further output modules as well as input modules and a connection means for electrical connection of said modules, **characterised in that**
each of said further output modules is equipped with a switching means for adjustment of a number, which represents a position on the connection means of the switching device, wherein all input modules are assigned to each output module from the position adjusted on this output module to the next highest position adjusted on another output module minus 1, wherein all input modules are assigned to the output module with the highest adjusted position from this position to the last position.

2. Module switching device according to claim 1, **characterised in that** in addition to said input and output modules other modules are also included, the assignment of which to the input and output modules is determined in another way.

## Revendications

1. Appareil de commutation modulaire comportant un premier module de sortie et d'autres modules de sortie ainsi que des modules d'entrée et un dispositif de connexion destiné à la connexion électrique des modules mentionnés,
**caractérisé en ce que** chacun des autres modules de sortie mentionnés est équipé d'un dispositif de commutation destiné au réglage d'un chiffre qui représente une position sur le dispositif de connexion de l'appareil de commutation, à chaque module de sortie étant affectés tous les modules d'entrée à partir de la position réglée sur ce module de sortie jusqu'à la position immédiatement supérieure moins 1 réglée sur un autre module de sortie, au module de sortie avec le réglage de position le plus élevé étant affectés tous les modules d'entrée à partir de cette position jusqu'à la dernière position.

2. Appareil de commutation modulaire selon la revendication 1, **caractérisé en ce que,** en plus des modules d'entrée et de sortie mentionnés, celui-ci comporte aussi d'autres modules dont l'affectation aux modules d'entrée et de sortie est déterminée d'une autre manière.
